(19) Europäisches Patentamt
European Patent Office
Office européen des brevets

(11) EP 3 633 749 A1

(12) **EUROPEAN PATENT APPLICATION**
published in accordance with Art. 153(4) EPC

(43) Date of publication:
**08.04.2020 Bulletin 2020/15**

(21) Application number: **18805801.0**

(22) Date of filing: **11.05.2018**

(51) Int Cl.:
***H01L 51/46*** *(2006.01)*
***C09D 5/24*** *(2006.01)*
***C09D 7/63*** *(2018.01)*
***C09D 201/00*** *(2006.01)*
***H01B 1/20*** *(2006.01)*
***H01L 51/48*** *(2006.01)*

(86) International application number:
**PCT/JP2018/018309**

(87) International publication number:
**WO 2018/216507 (29.11.2018 Gazette 2018/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.05.2017 JP 2017103207**

(71) Applicant: **Nissan Chemical Corporation**
**Tokyo 103-6119 (JP)**

(72) Inventors:
- **OSHIMA, Juro**
**Funabashi-shi**
**Chiba 274-0052 (JP)**
- **YOSHIMOTO, Takuji**
**Funabashi-shi**
**Chiba 274-0052 (JP)**

(74) Representative: **Mewburn Ellis LLP**
**City Tower**
**40 Basinghall Street**
**London EC2V 5DE (GB)**

# (54) METHOD FOR PRODUCING CHARGE TRANSPORTING THIN FILM

(57) This method for producing a charge transporting thin film, wherein a charge transporting varnish containing a charge transporting substance, an electron accepting dopant substance containing at least one substance selected from among naphthalene sulfonates and benzene sulfonates, and an organic solvent is applied onto a substrate and is subsequently heated at 100-180°C so that the organic solvent is evaporated therefrom, is capable of efficiently producing a charge transporting thin film which is able to be used as a hole collecting layer that enables the achievement of an organic photoelectric conversion element having high photoelectric conversion efficiency.

EP 3 633 749 A1

## Description

### TECHNICAL FIELD

The present invention relates to a method for producing a charge transporting thin film, more specifically, it relates to a method for producing a charge transporting thin film from a charge transporting varnish in which a dopant substance containing naphthalenesulfonic acid or benzenesulfonic acid is used by a coating method.

### BACKGROUND ART

Organic solar cells are a solar cell element in which an organic substance is used in an active layer and a charge transporting substance, and dye-sensitized solar cells developed by M. Gratzel and organic thin-film solar cells developed by C. W. Tang are well known (Non-patent Documents 1 and 2).

Both of these are lightweight and thin and have different characteristics from the inorganic solar cells which are currently the mainstream that these can be fabricated to be flexible and can be produced by roll-to-roll process, and thus a new market formation is expected.

Among these, organic thin-film solar cells have attracted a great deal of attention since the cells have features of being free of an electrolyte and free of a heavy metal compound as well as have been recently reported to have a photoelectric conversion efficiency (hereinafter abbreviated as PCE) of 10.6% by the groups of UCLA and others (Non-patent Document 3).

Meanwhile, organic thin-film solar cells have attracted attention not only for solar cell applications but also for optical sensor applications including organic CMOS image sensors since the cells have features of having a high photoelectric conversion efficiency even at a low illuminance as compared to photoelectric conversion elements in which existing silicon-based materials are used, of being able to be subjected to element thinning and pixel miniaturization, and of being able to exhibit the properties of a color filter (Non-patent Document 4). Hereinafter, the organic thin-film solar cells are generalized and referred to organic photoelectric conversion elements (hereinafter abbreviated as OPV in some cases).

The organic photoelectric conversion elements include an active layer (photoelectric conversion layer), a charge (hole, electron) collecting layer, an electrode (anode, cathode), and the like.

Among these, the active layer and the charge collecting layer are generally formed by a vacuum deposition method, but the vacuum deposition method has problems in terms of the complexity due to the mass production process, the high cost of the apparatus, the utilization efficiency of materials, and the like.

From these viewpoints, water dispersible polymer organic conductive materials such as PEDOT/PSS may be used as a coating type material for hole collecting layer, but there are problems that it is difficult to completely remove moisture and to control reabsorption of moisture and the deterioration of the element is likely to be accelerated since the materials are an aqueous dispersion.

Moreover, the PEDOT/PSS aqueous dispersion has the property that the solids easily aggregate and thus has problems that coating film defects are likely to be generated, clogging and corrosion of the coating apparatus are likely to occur as well as is insufficient in terms of heat resistance and thus still has various problems for mass production.

### PRIOR ART DOCUMENTS

### NON-PATENT DOCUMENTS

Non-patent Document 1: Nature, vol.353, 737-740(1991)

Non-patent Document 2: Appl. Phys. Lett., Vol.48, 183-185 (1986)

Non-patent Document 3: Nature Photonics Vol.6, 153-161 (2012)

Non-patent Document 4: Scientific Reports, Vol.5:7708, 1-7 (2015)


### SUMMARY OF INVENTION

### TECHNICAL PROBLEM

The present invention has been made in view of the above circumstances, and an object thereof is to provide a method for producing a charge transporting thin film capable of being utilized as a hole collecting layer providing an organic photoelectric conversion element having a high photoelectric conversion efficiency.

## SOLUTION TO PROBLEM

The present inventors have conducted intensive investigations to achieve the above object, as a result, have found out that thinning of a thin film containing a sublimable and evaporable film constituent can be prevented by applying a charge transporting varnish and then forming a thin film at a baking temperature in a specific range, and at the same time, a host material can be effectively doped by using naphthalenesulfonic acid and benzenesulfonic acid which have a low molecular weight and small steric hindrance, as a result, a thin film exhibiting excellent charge transporting property can be obtained even when a host material exhibiting low doping property is used, and thus have completed the present invention.

In other words, the present invention provides the following.

1. A method for producing a charge transporting thin film, including applying a charge transporting varnish containing a charge transporting substance, an electron accepting dopant substance containing at least one kind selected from naphthalenesulfonic acid and benzenesulfonic acid, and an organic solvent on a substrate and heating the charge transporting varnish at 100°C to 180°C to evaporate the organic solvent.
2. The method for producing a charge transporting thin film of 1, wherein the charge transporting substance is a charge transporting substance having a molecular weight of 200 to 2,000.
3. The method for producing a charge transporting thin film of 1 or 2, wherein the charge transporting substance is at least one kind selected from an aniline derivative and a thiophene derivative.
4. The method for producing a charge transporting thin film of any one of 1 to 3, wherein the heating is performed for 1 to 30 minutes.
5. A method for producing an organic photoelectric conversion element, including a step of fabricating a charge transporting thin film by the production method of any one of 1 to 4.
6. A method for producing an organic photoelectric conversion element, including forming a charge transporting thin film on an anode layer by the production method of any one of 1 to 4, then applying an active layer composition on this thin film to form an active layer, and further forming a negative electrode on this active layer.
7. The method for producing an organic photoelectric conversion element of 5 or 6, wherein the organic photoelectric conversion element is an organic thin-film solar cell or an optical sensor.
8. A charge transporting varnish containing a charge transporting substance; an electron accepting dopant substance containing at least one kind selected from naphthalenesulfonic acid and benzenesulfonic acid; and an organic solvent.
9. The charge transporting varnish of 8, containing at least one kind selected from 1-naphthalenesulfonic acid and benzenesulfonic acid.
10. The charge transporting varnish of 8 or 9, which is used in formation of a hole collecting layer of an organic photoelectric conversion element.
11. The charge transporting varnish of 10, wherein the organic photoelectric conversion element is an organic thin-film solar cell or an optical sensor.
12. A charge transporting thin film to be fabricated from the charge transporting varnish of 8 or 9.
13. A hole collecting layer to be fabricated from the charge transporting varnish of 10.
14. The hole collecting layer of 13, which provides an organic photoelectric conversion element having a photoelectric conversion efficiency of 4.0% or more when being interposed between an anode and an active layer.
15. An organic photoelectric conversion element including the hole collecting layer of 13 and an active layer provided so as to be in contact with the hole collecting layer.
16. The organic photoelectric conversion element of 15, wherein the active layer contains a fullerene derivative.
17. The organic photoelectric conversion element of 15 or 16, wherein the active layer contains a polymer containing a thiophene skeleton in a main chain.
18. The organic photoelectric conversion element of any one of 15 to 17, which is an organic thin-film solar cell.
19. The organic photoelectric conversion element of any one of 15 to 17, which is an optical sensor.

## ADVANTAGEOUS EFFECTS OF INVENTION

In the method for producing a charge transporting thin film of the present invention, thinning of a thin film containing a sublimable and evaporable film constituent can be prevented by applying a charge transporting varnish and then forming a thin film at a baking temperature in a specific range, and at the same time, a host material can be effectively doped by using naphthalenesulfonic acid and benzenesulfonic acid which have a low molecular weight and small steric hindrance, as a result, a thin film exhibiting excellent charge transporting property can be obtained even when a host material exhibiting low doping property is used.

By using a thin film fabricated using the charge transporting varnish of the present invention by the production method of the present invention as a hole collecting layer of an organic photoelectric conversion element, it is possible

to obtain an organic photoelectric conversion element having a high photoelectric conversion efficiency of 4.0% or more, more than 4.0%, or in some cases 4.5% or more. In addition, the charge transporting varnish of the present invention is a uniform organic solution, thus is highly suitable for a mass production process, and exhibits high uniform film forming property while flattening the underlying anode with irregularities, and thus can realize a high yield of element, suppress current leakage, and keep the reverse bias dark current low.

Furthermore, the organic photoelectric conversion element of the present invention has a high conversion efficiency with respect to visible light, near-ultraviolet light, and near-infrared light without depending on the irradiation light intensity and exhibits high durability.

For these properties, the organic photoelectric conversion element of the present invention can also be suitably used in the optical sensor applications including an image sensor as well as can be used as an organic thin-film solar cell in applications such as solar power generation and indoor photovoltaic power generation.

## DESCRIPTION OF EMBODIMENTS

Hereinafter, the present invention is described in more detail.

The method for producing a charge transporting thin film according to the present invention includes applying a charge transporting varnish containing a charge transporting substance, an electron accepting dopant substance containing at least one kind selected from naphthalenesulfonic acid and benzenesulfonic acid, and an organic solvent on a substrate and heating the charge transporting varnish at 100°C to 180°C to evaporate the organic solvent.

By performing heating in this temperature range, it is possible to fabricate a charge transporting thin film maintaining a specific film thickness without causing the film thinning problem described above.

The heating temperature may be appropriately set in the above range in consideration of the heating time and the like but is preferably 110°C to 180°C and more preferably 120°C to 150°C when efficient formation of the thin film is taken into consideration.

The heating time varies depending on the heating temperature, the intended film thickness and the like, thus cannot be unconditionally regulated, but in the present invention, is preferably about 1 to 30 minutes and more preferably about 5 to 20 minutes from the above heating temperature range and the application of the thin film.

Incidentally, preliminary heating (pre-baking) and final heating (post-baking) at a temperature less than the above heating temperature range may be performed if necessary.

As a coating method, an optimum method among various wet process methods such as a drop casting method, a spin coating method, a blade coating method, a dip coating method, a roll coating method, a bar coating method, a die coating method, an ink jet method, and a printing method (relief printing, intaglio, planography, screen printing, or the like) may be employed in consideration of the viscosity and surface tension of the varnish, the desired thin film thickness, and the like.

Usually, coating is performed in an inert gas atmosphere at normal temperature and normal pressure but may be performed in an air atmosphere (in the presence of oxygen) as long as the compounds in the varnish are not decomposed or the composition does not greatly change or may be performed while performing heating at a temperature equal to or less than the above temperature range.

As the substrate, an optimal substrate may be employed depending on the application of the charge transporting thin film, but the anode serves as the substrate in the case of using the charge transporting thin film as a hole collecting layer of an organic photoelectric conversion element or a hole injected layer of an organic electroluminescence element.

The film thickness of the charge transporting thin film to be fabricated by the production method of the present invention is usually about 1 to 200 nm but preferably about 3 to 100 nm and more preferably 3 to 30 nm. As the method for changing the film thickness, there are methods in which the solid concentration in the varnish is changed, the amount of solution at the time of coating is changed, or the like.

The charge transporting varnish to be used in the production method of the present invention contains a charge transporting substance, an electron accepting dopant substance, and an organic solvent. The electron accepting dopant substance contains at least one kind of naphthalenemonosulfonic acid or benzenemonosulfonic acid selected from naphthalenesulfonic acid and benzenesulfonic acid.

In the present invention, the molecular weight of the charge transporting substance is not particularly limited but, in consideration of conductivity, is preferably 200 to 2,000 and the lower limit thereof is preferably 300 or more and more preferably 400 or more. In consideration of the improvement in solubility in a solvent, the upper limit thereof is preferably 1,500 or less and more preferably 1,000 or less.

The charge transporting substance may be appropriately selected from known charge transporting substances and used but is preferably an aniline derivative or a thiophene derivative and particularly preferably an aniline derivative.

Specific examples of these aniline derivatives and thiophene derivatives include those disclosed in, for example, WO 2005/043962, WO 2013/042623, and WO 2014/141998.

More specific examples thereof include those represented by the following formulas (HI) to (H3).

[Chem. 1]

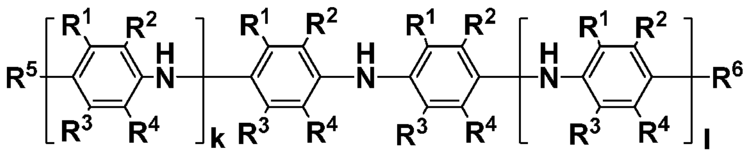

(H1)

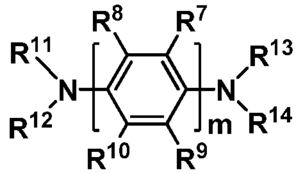

(H2)

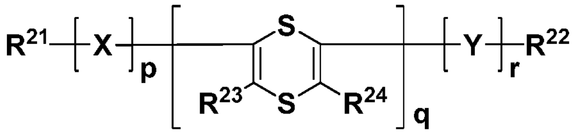

(H3)

Incidentally, the aniline derivative represented by formula (HI) may be an oxidized aniline derivative (quinonediimine derivative) having a quinonediimine structure represented by the following formula in the molecule. Examples of the method for oxidizing an aniline derivative into a quinonediimine derivative include the methods described in WO 2008/010474 and WO 2014/119782.

[Chem. 2]

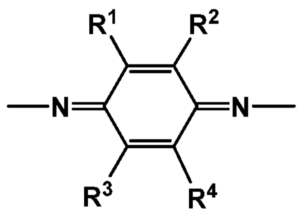

In formula (H1), $R^1$ to $R^6$ each independently denote a hydrogen atom, a halogen atom, a nitro group, a cyano group, an amino group, an alkyl group having 1 to 20 carbon atoms, an alkenyl group having 2 to 20 carbon atoms, or an alkynyl group having 2 to 20 carbon atoms, which may be substituted with $Z^1$, an aryl group having 6 to 20 carbon atoms or a heteroaryl group having 2 to 20 carbon atoms, which may be substituted with $Z^2$, $-NHY^1$, $-NY^2Y^3$, $-OY^4$, or $-SY^5$ group; $Y^1$ to $Y^5$ each independently denote an alkyl group having 1 to 20 carbon atoms, an alkenyl group having 2 to 20 carbon atoms, or an alkynyl group having 2 to 20 carbon atoms, which may be substituted with $Z^1$ or an aryl group having 6 to 20 carbon atoms or a heteroaryl group having 2 to 20 carbon atoms, which may be substituted with $Z^2$, $Z^1$ denotes a halogen atom, a nitro group, a cyano group, an amino group, or an aryl group having 6 to 20 carbon atoms or a heteroaryl group having 2 to 20 carbon atoms, which may be substituted with $Z^3$; $Z^2$ denotes a halogen atom, a nitro group, a cyano group, an amino group, or an alkyl group having 1 to 20 carbon atoms, an alkenyl group having 2 to 20 carbon atoms, or an alkynyl group having 2 to 20 carbon atoms, which may be substituted with $Z^3$; $Z^3$ denotes a halogen atom, a nitro group, a cyano group, or an amino group, and k and 1 each independently denote an integer from 1 to 5.

In formula (H2), $R^7$ to $R^{10}$ each independently denote a hydrogen atom, a halogen atom, a nitro group, a cyano group, a hydroxyl group, a thiol group, a phosphoric acid group, a sulfonic acid group, a carboxyl group, an alkoxy group having 1 to 20 carbon atoms, a thioalkoxy group having 1 to 20 carbon atoms, an alkyl group having 1 to 20 carbon atoms, an alkenyl group having 2 to 20 carbon atoms, or an alkynyl group having 2 to 20 carbon atoms, which may be substituted with $Z^1$, an aryl group having 6 to 20 carbon atoms or an aralkyl group having 7 to 20 carbon atoms, which may be substituted with $Z^2$, or an acyl group having 1 to 20 carbon atoms, $R^{11}$ to $R^{14}$ each independently denote a hydrogen atom, a phenyl group, a naphthyl group, a pyridyl group, a pyrimidinyl group, a pyridazinyl group, a pyrazinyl group, a furanyl group, a pyrrolyl group, a pyrazolyl group, an imidazolyl group, a thienyl group (these groups may be substituted with a halogen atom, a nitro group, a cyano group, a hydroxyl group, a thiol group, a phosphoric acid group,

a sulfonic acid group, a carboxyl group, an alkoxy group having 1 to 20 carbon atoms, a thioalkoxy group having 1 to 20 carbon atoms, an alkyl group having 1 to 20 carbon atoms, a haloalkyl group having 1 to 20 carbon atoms, an alkenyl group having 2 to 20 carbon atoms, an alkynyl group having 2 to 20 carbon atoms, an aryl group having 6 to 20 carbon atoms, an aralkyl group having 7 to 20 carbon atoms, or an acyl group having 1 to 20 carbon atoms), or a group represented by formula (H4) (provided that at least one of $R^{11}$ to $R^{14}$ denotes a hydrogen atom), and m denotes an integer from 2 to 5. $Z^1$ and $Z^2$ are synonymous with those described above.

[Chem. 3]

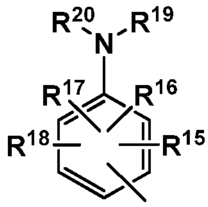

(H4)

In formula (H4), $R^{15}$ to $R^{18}$ each independently denote a hydrogen atom, a halogen atom, a nitro group, a cyano group, a hydroxyl group, a thiol group, a phosphoric acid group, a sulfonic acid group, a carboxyl group, or an alkoxy group having 1 to 20 carbon atoms, a thioalkoxy group having 1 to 20 carbon atoms, an alkyl group having 1 to 20 carbon atoms, an alkenyl group having 2 to 20 carbon atoms, or an alkynyl group having 2 to 20 carbon atoms, which may be substituted with $Z^1$, an aryl group having 6 to 20 carbon atoms or an aralkyl group having 7 to 20 carbon atoms, which may be substituted with $Z^2$, or an acyl group having 1 to 20 carbon atoms and $R^{19}$ and $R^{20}$ each independently denote a phenyl group, a naphthyl group, an anthryl group, a pyridyl group, a pyrimidinyl group, a pyridazinyl group, a pyrazinyl group, a furanyl group, a pyrrolyl group, a pyrazolyl group, an imidazolyl group, or a thienyl group (these groups may be bonded to each other to form a ring or may be substituted with a halogen atom, a nitro group, a cyano group, a hydroxyl group, a thiol group, a phosphoric acid group, a sulfonic acid group, a carboxyl group, an alkoxy group having 1 to 20 carbon atoms, a thioalkoxy group having 1 to 20 carbon atoms, an alkyl group having 1 to 20 carbon atoms, a haloalkyl group having 1 to 20 carbon atoms, an alkenyl group having 2 to 20 carbon atoms, an alkynyl group having 2 to 20 carbon atoms, an aryl group having 6 to 20 carbon atoms, an aralkyl group having 7 to 20 carbon atoms, or an acyl group having 1 to 20 carbon atoms). $Z^1$ and $Z^2$ are synonymous with those described above.

In formula (H3), $R^{21}$ to $R^{24}$ each independently denote a hydrogen atom, a halogen atom, a hydroxyl group, an amino group, a silanol group, a thiol group, a carboxyl group, a sulfonic acid group, a phosphoric acid group, a phosphoric acid ester group, an ester group, a thioester group, an amide group, a nitro group, an alkyl group having 1 to 20 carbon atoms, an alkenyl group having 2 to 20 carbon atoms, or an alkynyl group having 2 to 20 carbon atoms, which may be substituted with $Z^1$, an aryl group having 6 to 20 carbon atoms or an aralkyl group having 7 to 20 carbon atoms, which may be substituted with $Z^2$, an acyl group having 1 to 20 carbon atoms, a sulfonic acid group, $-NHY^1$, $-NY^2Y^3$, $-OY^4$, $-SY^5$, or $-SiY^6Y^7Y^8$, $Y^1$ to $Y^8$ each independently denote an alkyl group having 1 to 20 carbon atoms, an alkenyl group having 2 to 20 carbon atoms, or an alkynyl group having 2 to 20 carbon atoms, which may be substituted with $Z^1$ or an aryl group having 6 to 20 carbon atoms or a heteroaryl group having 2 to 20 carbon atoms, which may be substituted with $Z^2$, X and Y each independently denote a thiophene ring which may be substituted with $Z^2$, and two sulfur atoms contained in the dithiine ring may each independently denote a SO group or a $SO_2$ group. p, q, and r each independently denote 0 or an integer 1 or more and are numbers satisfying $p + q + r \leq 20$. $Z^1$ and $Z^2$ are synonymous with those described above.

In the above formulas, examples of the halogen atom include a fluorine atom, a chlorine atom, a bromine atom, and an iodine atom.

The alkyl group having 1 to 20 carbon atoms may be linear, branched, or cyclic, and examples thereof include linear or branched alkyl groups having 1 to 20 carbon atoms such as a methyl group, an ethyl group, a n-propyl group, an isopropyl group, a n-butyl group, an isobutyl group, a s-butyl group, a t-butyl group, a n-pentyl group, a n-hexyl group, a n-heptyl group, a n-octyl group, a n-nonyl group, and a n-decyl group; cyclic alkyl groups having 3 to 20 carbon atoms such as a cyclopropyl group, a cyclobutyl group, a cyclopentyl group, a cyclohexyl group, a cycloheptyl group, a cyclooctyl group, a cyclononyl group, a cyclodecyl group, a bicyclobutyl group, a bicyclopentyl group, a bicyclohexyl group, a bicycloheptyl group, a bicyclooctyl group, a bicyclononyl group, and a bicyclodecyl group.

Specific examples of the alkenyl group having 2 to 20 carbon atoms include an ethenyl group, a n-1-propenyl group, a n-2-propenyl group, a 1-methylethenyl group, a n-1-butenyl group, a n-2-butenyl group, a n-3-butenyl group, a 2-methyl-1-propenyl group, a 2-methyl-2-propenyl group, a 1-ethylethenyl group, a 1-methyl-1-propenyl group, a 1-methyl-2-propenyl group, a n-1-pentenyl group, a n-1-decenyl group, and a n-1-eicocenyl group.

Specific examples of the alkynyl group having 2 to 20 carbon atoms include an ethynyl group, a n-1-propynyl group, a n-2-propynyl group, a n-1-butynyl group, a n-2-butynyl group, a n-3-butynyl group, a 1-methyl-2-propynyl group, a n-1-pentynyl group, a n-2-pentynyl group, a n-3-pentynyl group, a n-4-pentynyl group, a 1-methyl-n-butynyl group, a 2-methyl-n-butynyl group, a 3-methyl-n-butynyl group, a 1,1-dimethyl-n-propynyl group, a n-1-hexynyl group, a n-1-decynyl group, a n-1-pentadecynyl group, and a n-1-eicosinyl group.

Specific examples of the aryl group having 6 to 20 carbon atoms include a phenyl group, a 1-naphthyl group, a 2-naphthyl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

Specific examples of the aralkyl group having 7 to 20 carbon atoms include a benzyl group, a phenylethyl group, a phenylpropyl group, a naphthylmethyl group, a naphthylethyl group, and a naphthylpropyl group.

Specific examples of the heteroaryl group having 2 to 20 carbon atoms include a 2-thienyl group, a 3-thienyl group, a 2-furanyl group, a 3-furanyl group, a 2-oxazolyl group, a 4-oxazolyl group, a 5-oxazolyl group, a 3-isoxazolyl group, a 4-isoxazolyl group, a 5-isoxazolyl group, a 2-thiazolyl group, a 4-thiazolyl group, a 5-thiazolyl group, a 3-isothiazolyl group, a 4-isothiazolyl group, a 5-isothiazolyl group, a 2-imidazolyl group, a 4-imidazolyl group, a 2-pyridyl group, a 3-pyridyl group, and a 4-pyridyl group.

Examples of the haloalkyl group having 1 to 20 carbon atoms include those obtained by substituting at least one hydrogen atom of the alkyl group having 1 to 20 carbon atoms with a halogen atom. Among these, a fluoroalkyl group is preferable and a perfluoroalkyl group is more preferable.

Specific examples thereof include a fluoromethyl group, a difluoromethyl group, a trifluoromethyl group, a pentafluoroethyl group, a 2,2,2-trifluoroethyl group, a heptafluoropropyl group, a 2,2,3,3,3-pentafluoropropyl group, a 2,2,3,3-tetrafluoropropyl group, a 2,2,2-trifluoro-1-(trifluoromethyl)ethyl group, a nonafluorobutyl group, a 4,4,4-trifluorobutyl group, an undecafluoropentyl group, a 2,2,3,3,4,4,5,5,5-nonafluoropentyl group, a 2,2,3,3,4,4,5,5-octafluoropentyl group, a tridecafluorohexyl group, a 2,2,3,3,4,4,5,5,6,6,6-undecafluorohexyl group, a 2,2,3,3,4,4,5,5,6,6-decafluorohexyl group, and a 3,3,4,4,5,5,6,6,6-nonafluorohexyl group.

Specific examples of the alkoxy group having 1 to 20 carbon atoms include a methoxy group, an ethoxy group, a n-propoxy group, an i-propoxy group, a c-propoxy group, a n-butoxy group, an i-butoxy group, a s-butoxy group, a t-butoxy group, a n-pentoxy group, a n-hexoxy group, a n-heptyloxy group, a n-octyloxy group, a n-nonyloxy group, a n-decyloxy group, a n-undecyloxy group, a n-dodecyloxy group, a n-tridecyloxy group, a n-tetradecyloxy group, a n-pentadecyloxy group, a n-hexadecyloxy group, a n-heptadecyloxy group, a n-octadecyloxy group, a n-nonadecyloxy group, and a n-eicosanyloxy group.

Specific examples of the thioalkoxy (alkylthio) group having 1 to 20 carbon atoms include a methylthio group, an ethylthio group, a n-propylthio group, an isopropylthio group, a n-butylthio group, an isobutylthio group, a s-butylthio group, a t-butylthio group, a n-pentylthio group, a n-hexylthio group, a n-heptylthio group, a n-octylthio group, a n-nonylthio group, a n-decylthio group, a n-undecylthio group, a n-dodecylthio group, a n-tridecylthio group, a n-tetradecylthio group, a n-pentadecylthio group, a n-hexadecylthio group, a n-heptadecylthio group, a n-octadecylthio group, a n-nonadecylthio group, and a n-eicosanylthio group.

Specific examples of the acyl group having 1 to 20 carbon atoms include a formyl group, an acetyl group, a propionyl group, a butyryl group, an isobutyryl group, a valeryl group, an isovaleryl group, and a benzoyl group.

In formula (H1), $R^1$ to $R^6$ preferably denote a hydrogen atom, a halogen atom, an alkyl group having 1 to 20 carbon atoms which may be substituted with $Z^1$, an aryl group having 6 to 20 carbon atoms which may be substituted with $Z^2$, $-NHY^1$, $-NY^2Y^3$, $-OY^4$, or $-SY^5$, in this case, $Y^1$ to $Y^5$ denote preferably an alkyl group having 1 to 10 carbon atoms which may be substituted with $Z^1$ or an aryl group having 6 to 10 carbon atoms which may be substituted with $Z^2$, more preferably an alkyl group having 1 to 6 carbon atoms which may be substituted with $Z^1$ or a phenyl group which may be substituted with $Z^2$, and still more preferably an alkyl group having 1 to 6 carbon atoms or a phenyl group.

In particular, it is more preferable that $R^1$ to $R^6$ denote a hydrogen atom, a fluorine atom, a methyl group, a phenyl group, or a diphenylamino group ($-NY^2Y^3$ where $Y^2$ and $Y^3$ denote a phenyl group), and it is still more preferable that $R^1$ to $R^4$ denote a hydrogen atom and $R^5$ and $R^6$ simultaneously denote a hydrogen atom or a diphenylamino group.

In particular, in $R^1$ to $R^6$ and $Y^1$ to $Y^5$, $Z^1$ denotes preferably a halogen atom or an aryl group having 6 to 10 carbon atoms which may be substituted with $Z^3$ and more preferably a fluorine atom or a phenyl group and is still more preferably not present (that is, an unsubstituted group) and $Z^2$ denotes preferably a halogen atom or an alkyl group having 1 to 10 carbon atoms which may be substituted with $Z^3$ and more preferably a fluorine atom or an alkyl group having 1 to 6 carbon atoms and is still more preferably not present (that is, an unsubstituted group).

In addition, $Z^3$ denotes preferably a halogen atom and more preferably a fluorine atom and is still more preferably not present (that is, an unsubstituted group).

k and 1 are preferably $k + 1 \leq 8$ and more preferably $k + 1 \leq 5$ from the viewpoint of enhancing the solubility of the aniline derivative represented by formula (HI).

In formula (H2), $R^7$ to $R^{10}$ denote preferably a hydrogen atom, a halogen atom, an alkyl group having 1 to 4

carbon atoms, a perfluoroalkyl group having 1 to 4 carbon atoms, or an alkoxy group having 1 to 4 carbon atoms and more preferably a hydrogen atom.

In addition, it is preferable that both $R^{11}$ and $R^{13}$ denote a hydrogen atom in consideration of enhancement of the solubility of the aniline derivative represented by formula (H2) in the solvent and enhancement of the uniformity of the thin film to be obtained.

In particular, it is preferable that both $R^{11}$ and $R^{13}$ denote a hydrogen atom and $R^{12}$ and $R^{14}$ each independently denote a phenyl group (this phenyl group may be substituted with a halogen atom, a nitro group, a cyano group, a hydroxyl group, a thiol group, a phosphoric acid group, a sulfonic acid group, a carboxyl group, an alkoxy group having 1 to 20 carbon atoms, a thioalkoxy group having 1 to 20 carbon atoms, an alkyl group having 1 to 20 carbon atoms, a haloalkyl group having 1 to 20 carbon atoms, an alkenyl group having 2 to 20 carbon atoms, an alkynyl group having 2 to 20 carbon atoms, an aryl group having 6 to 20 carbon atoms, an aralkyl group having 7 to 20 carbon atoms, or an acyl group having 1 to 20 carbon atoms) or a group represented by formula (H4) above, it is more preferable that both $R^{11}$ and $R^{13}$ denote a hydrogen atom and $R^{12}$ and $R^{14}$ each independently denote a phenyl group or a group represented by the following formula (H4') where both $R^{19'}$ and $R^{20'}$ denote a phenyl group, and it is still more preferable that both $R^{11}$ and $R^{13}$ denote a hydrogen atom and both $R^{12}$ and $R^{14}$ denote a phenyl group.

In addition, as m, 2 to 4 is preferable in consideration of availability of the compound, ease of production, cost, and the like, 2 or 3 is more preferable in consideration of enhancement of the solubility in a solvent, and 2 is optimal in consideration of the balance among availability of the compound, ease of production, production cost, solubility in a solvent, transparency of the thin film to be obtained, and the like.

[Chem. 4]

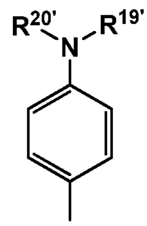

**(H4')**

In formula (H3), $R^{21}$ to $R^{24}$ denote preferably a hydrogen atom, a fluorine atom, a sulfonic acid group, an alkyl group having 1 to 8 carbon atoms, a $-OY^4$ group, or a $-SiY^6Y^7Y^8$ group and more preferably a hydrogen atom.

In addition, from the viewpoint of enhancing the solubility of the compound, it is preferable that p, q, and r each denote 1 or more and $p + q + r \leq 20$ and it is more preferable that p, q, and r each denote 1 or more and $p + q + r \leq 10$. Furthermore, from the viewpoint of exerting high charge transporting property, it is preferable that p, q, and r each denote 1 or more and $5 \leq p + q + r$ and it is more preferable that q denotes 1, p and r each denote 1 or more, and $5 \leq p + q + r$.

As the aniline derivatives or thiophene derivatives represented by formulas (HI) to (H3), commercially available products may be used or those produced by known methods such as the methods described in the respective publications described above, but it is preferable to use those purified by recrystallization, a vapor deposition method and the like before preparation of the charge transporting varnish in any case. By using those purified, the characteristics of the organic photoelectric conversion element equipped with the thin film obtained from the varnish can be further enhanced. In the case of performing purification by recrystallization, for example, 1,4-dioxane and tetrahydrofuran can be used as the solvent.

In the charge transporting varnish of the present invention, as the charge transporting substances represented by formulas (HI) to (H3), one compound selected from the compounds represented by formulas (HI) to (H3) (that is, the degree of dispersion in the molecular weight distribution is 1) may be used singly or two or more compounds may be used in combination.

In particular, it is preferable to use an aniline derivative represented by formula (H2) from the viewpoint of enhancing the transparency of the hole collecting layer. Among these, it is more preferable to use a benzidine derivative in which above-mentioned m denotes 2 and it is still more preferable to use diphenylbenzidine represented by the following formula (g).

Specific examples of the charge transporting substance which can be suitably used in the present invention include the following, but are not limited thereto.

[Chem. 5]

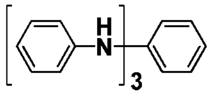

(a)

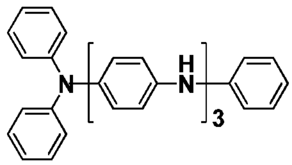

(b)

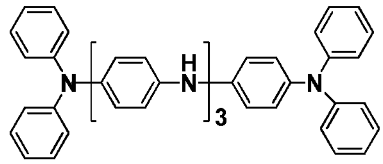

(c)

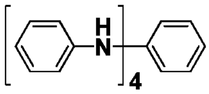

(d)

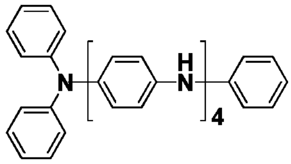

(e)

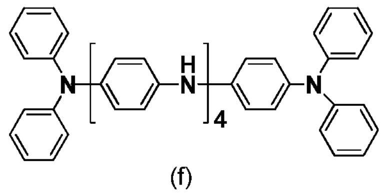

(f)

[Chem. 6]

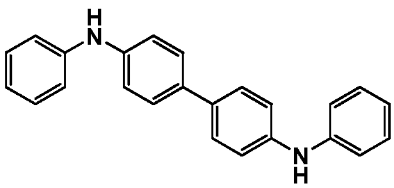

(g)

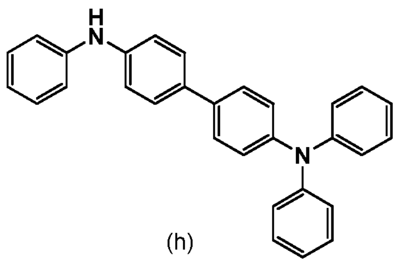

(h)

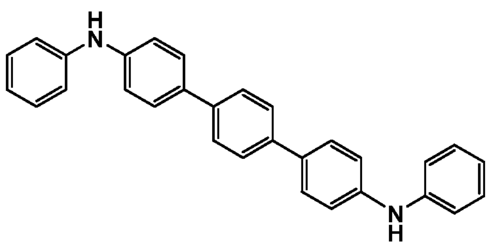

(i)

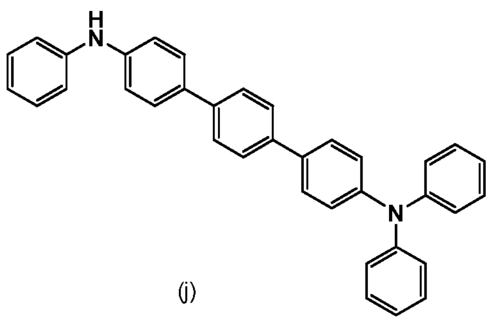

(j)

[Chem. 7]

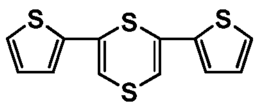

(k)

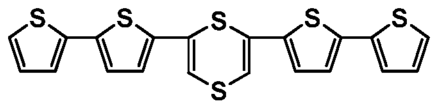

(l)

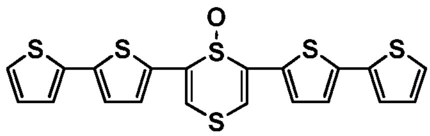

(m)

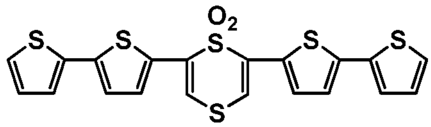

(n)

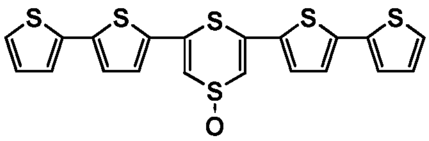

(o)

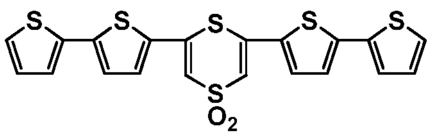

(p)

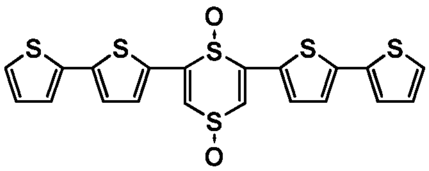

(q)

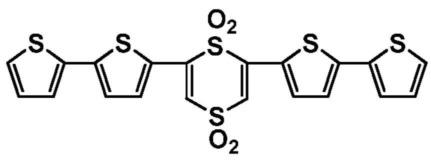

(r)

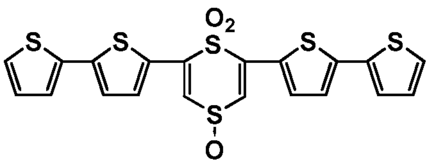

(s)

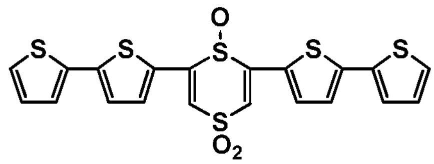

(t)

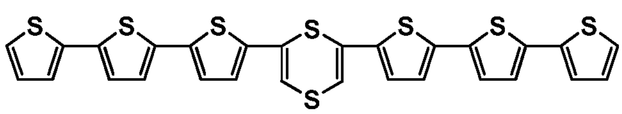

(u)

The charge transporting varnish of the present invention contains an electron accepting dopant substance containing at least one kind of naphthalenemonosulfonic acid or benzenemonosulfonic acid selected from naphthalenesulfonic acid and benzenesulfonic acid in addition to the charge transporting substance.

Specific examples of naphthalenesulfonic acid include 1-naphthalenesulfonic acid and 2-naphthalenesulfonic acid.

Among these, 1-naphthalenesulfonic acid and benzenesulfonic acid are preferable from the viewpoint of further increasing the photoelectric conversion efficiency of the organic photoelectric conversion element using the charge transporting thin film to be obtained.

Moreover, the charge transporting varnish may contain other electron accepting dopant substances in addition to the naphthalenemonosulfonic acid or benzenemonosulfonic acid depending on the application of the thin film to be obtained for the purpose of improving the photoelectric conversion efficiency of the organic photoelectric conversion element to be obtained, and the like.

Other electron accepting dopant substances are not particularly limited as long as they are dissolved in at least one kind of solvent to be used in the charge transporting varnish.

Specific examples of other electron accepting dopant substances include inorganic strong acids such as hydrogen chloride, sulfuric acid, nitric acid, and phosphoric acid; Lewis acids such as aluminum chloride (III) ($AlCl_3$), titanium tetrachloride (IV) ($TiCl_4$), boron tribromide ($BBr_3$), boron trifluoride ether complex ($BF_3 \cdot OFt_2$), iron chloride (III) ($FeCl_3$), copper chloride (II) ($CuCl_2$), antimony pentachloride (V) ($SbCl_5$), arsenic pentafluoride (V) (AsFs), phosphorus pentafluoride ($PF_5$), and tris(4-bromophenyl)aluminum hexachloroantimonate (TBPAH); strong organic acids such as aryl sulfonic acid compounds such as benzenesulfonic acid, tosylic acid, camphorsulfonic acid, hydroxybenzenesulfonic acid, 5-sulfosalicylic acid, dodecylbenzenesulfonic acid, polystyrenesulfonic acid, a 1,4-benzodioxane disulfonic acid compound described in WO 2005/000832, a naphthalene- or anthracenesulfonic acid compound described in WO 2006/025342, and a dinonylnaphthalenesulfonic acid compound described in JP-A 2005-108828; organic oxidants such as 7,7,8,8-tetracyanoquinodimethane (TCNQ), 2,3-dichloro-5,6-dicyano-1,4-benzoquinone (DDQ), and iodine, and inorganic oxidants such as heteropolyacids such as phosphomolybdic acid, phosphotungstic acid, and phosphotungstomolybdic acid which are described in WO 2010/058777, and these may be used in combination.

As the organic solvent to be used in the preparation of the charge transporting varnish, a highly soluble solvent capable of favorably dissolving the charge transporting substance and the electron accepting dopant substance can be used. Highly soluble solvents can be used singly or in combination of two or more kinds thereof, and the amount thereof used can be set to 5% to 100% by weight with respect to the entire solvent to be used in the varnish.

Examples of such highly soluble solvents include N-methylformamide, N,N-dimethylformamide, N,N-diethylformamide, N-methylacetamide, N,N-dimethylacetamide, N-methylpyrrolidone, and 1,3-dimethyl-2-imidazolidinone.

Among these, N-methylformamide, N,N-dimethylformamide, N,N-diethylformamide, N-methylacetamide, and N,N-dimethylacetamide which are amide-based solvents are preferable and N,N-dimethylacetamide is more preferable.

It is preferable that the charge transporting substance and the electron accepting dopant substance are both completely dissolved or uniformly dispersed in the organic solvent, and it is more preferable that these materials are completely dissolved in the organic solvent in consideration of obtaining a hole collecting layer providing an organic photoelectric conversion element having a high photoelectric conversion efficiency with favorable reproducibility.

It is preferable that the charge transporting varnish of the present invention has a viscosity of 10 to 200 mPa·s, particularly 35 to 150 mPa·s at 25°C and contains at least one kind of highly viscous organic solvent having a boiling point of 50°C to 300°C, particularly 150°C to 250°C at normal pressure.

The highly viscous organic solvent is not particularly limited, and examples thereof include cyclohexanol, ethylene glycol, 1,3-octylene glycol, diethylene glycol, dipropylene glycol, triethylene glycol, tripropylene glycol, 1,3-butanediol, 2,3-butanediol, 1,4-butanediol, propylene glycol, and hexylene glycol.

The proportion of the highly viscous organic solvent added with respect to the entire solvent to be used in the charge transporting varnish of the present invention is preferably in a range in which solids are not precipitated, and the proportion of the highly viscous organic solvent added is preferably 5% to 80% by weight as long as solids are not precipitated.

Furthermore, other solvents capable of imparting film flatness at the time of the heat treatment can also be mixed at a proportion of 1% to 90% by weight and preferably 1% to 50% by weight with respect to the entire solvent to be used in the varnish for the purpose of improving the wettability with respect to the coated surface, adjusting the surface tension of the solvent, adjusting the polarity, adjusting the boiling point, and the like.

Examples of such solvents include butyl cellosolve, diethylene glycol diethyl ether, diethylene glycol dimethyl ether, diethylene glycol monoethyl ether acetate, diethylene glycol monobutyl ether acetate, dipropylene glycol monomethyl ether, propylene glycol monomethyl ether, propylene glycol monomethyl ether acetate, ethyl carbitol, diacetone alcohol, γ-butyrolactone, ethyl lactate, and n-hexyl acetate, but are not limited thereto.

An organosilane compound may be added to the charge transporting varnish of the present invention from the viewpoint of improving the electron blocking property of the organic photoelectric conversion element to be obtained.

Examples of the organosilane compound include trialkoxysilane and dialkoxysilane, especially, aryltrialkoxysilane, aryldialkoxysilane, fluorine atom-containing trialkoxysilane, and a fluorine atom-containing dialkoxysilane compound are preferable, and a silane compound represented by formula (S1) or (S2) is more preferable.

[Chem. 8]

$RSi(OCH_3)_3$ (S1)

$RSi(OC_2H_5)_3$ (S2)

(Where R denotes a fluoroalkyl group having 1 to 6 carbon atoms.)

Specific examples of the fluoroalkyl group having 1 to 6 carbon atoms include a trifluoromethyl group, a 2,2,2-trifluoroethyl group, a 1,1,2,2,2-pentafluoroethyl group, a 3,3,3-trifluoropropyl group, a 2,2,3,3,3-pentafluoropropyl group, a 1,1,2,2,3,3,3-heptafluoropropyl group, a 4,4,4-trifluorobutyl group, a 3,3,4,4,4-pentafluorobutyl group, a 2,2,3,3,4,4,4-heptafluorobutyl group, and a 1,1,2,2,3,3,4,4,4-nonafluorobutyl group.

Specific examples of dialkoxysilane compounds include dimethyldimethoxysilane, dimethyldiethoxysilane, methylethyldimethoxysilane, diethyldimethoxysilane, diethyldiethoxysilane, methylpropyldimethoxysilane, methylpropyldiethoxysilane, diisopropyldimethoxysilane, phenylmethyldimethoxysilane, vinylmethyldimethoxysilane, 3-glycidoxypropylmethyldimethoxysilane, 3-glycidoxypropylmethyldiethoxysilane, 3-(3,4-epoxycyclohexyl)ethylmethyldimethoxysilane, 3-methacryloxypropylmethyldimethoxysilane, 3 methacryloxypropylmethyldiethoxysilane, 3-mercaptopropylmethyldimethoxysilane, γ-aminopropylmethyldiethoxysilane, N-(2-aminoethyl)aminopropylmethyldimethoxysilane, and 3,3,3-trifluoropropylmethyldimethoxysilane.

Specific examples of trialkoxysilane compounds include methyltrimethoxysilane, methyltriethoxysilane, ethyltrimethoxysilane, ethyltriethoxysilane, propyltrimethoxysilane, propyltriethoxysilane, butyltrimethoxysilane, butyltriethoxysilane, pentyltrimethoxysilane, pentyltriethoxysilane, heptyltrimethoxysilane, heptyltriethoxysilane, octyltrimethoxysilane, octyltriethoxysilane, dodecyltrimethoxysilane, dodecyltriethoxysilane, hexadecyltrimethoxysilane, hexadecyltriethoxysilane, octadecyltrimethoxysilane, octadecyltriethoxysilane, phenyltrimethoxysilane, phenyltriethoxysilane, vinyltrimethoxysilane, vinyltriethoxysilane, γ-aminopropyltrimethoxysilane, 3-aminopropyltriethoxysilane, γ-glycidoxypropyltrimethoxysilane, 3-glycidoxypropyltriethoxysilane, γ-methacryloxypropyltrimethoxysilane, γ-methacryloxypropyltriethoxysilane, triethoxy(4-(trifluoromethyl)phenyl)silane, dodecyltriethoxysilane, 3,3,3-trifluoropropyltrimethoxysilane, (triethoxysilyl)cyclohexane, perfluorooctylethyltriethoxysilane, triethoxyfluorosilane, tridecafluoro-1,1,2,2-tetrahydrooctyltriethoxysilane, 3 -(heptafluoroisopropoxy)propyltriethoxysilane, heptadecafluoro-1,1,2,2-tetrahydrodecyltriethoxysilane, triethoxy-2-thienylsilane, and 3-(triethoxysilyl)furan.

In the case of using an organosilane compound, the content thereof is usually about 0.1% to 200% by weight, but preferably 1% to 100% by weight, and more preferably 5% to 50% by weight with respect to the charge transporting substance and electron accepting dopant substance in the charge transporting varnish of the present invention.

The solid concentration in the charge transporting varnish of the present invention is appropriately set in consideration of the viscosity, surface tension and the like of the varnish, the thickness of the thin film to be fabricated, and the like, but is usually about 0.1% to 10.0% by weight, preferably 0.5% to 5.0% by weight, and more preferably 1.0% to 3.0% by weight.

Incidentally, solids mean components other than the organic solvent among the components constituting the charge transporting varnish.

In addition, the ratio of amount of substance (mol) between the charge transporting substance and the electron accepting dopant substance is also appropriately set in consideration of the charge transporting property to be exerted, the kind of the charge transporting substance, and the like, but the electron accepting dopant substance is usually 0.1 to 10, preferably 0.2 to 5.0, and more preferably 0.5 to 3.0 with respect to 1 of the charge transporting substance.

Moreover, the viscosity of the charge transporting varnish to be used in the present invention is appropriately adjusted depending on the coating method in consideration of the thickness and the like of the thin film to be fabricated and the solid concentration, but is usually about 0.1 to 50 mPa·s at 25°C.

When preparing the charge transporting varnish of the present invention, the charge transporting substance, the electron accepting dopant substance, and the organic solvent can be mixed in any order as long as the solids are uniformly dissolved or dispersed in the solvent. In other words, for example, any of a method in which the charge transporting substance is dissolved in the organic solvent and then the electron accepting dopant substance is dissolved in the solution, a method in which the electron accepting dopant substance is dissolved in the organic solvent and then the charge transporting substance is dissolved in the solution, or a method in which the charge transporting substance and the electron accepting dopant substance are mixed together and then the mixture is put and dissolved in the organic solvent can be employed as long as the solids are uniformly dissolved or dispersed in the organic solvent.

In addition, usually, the preparation of the charge transporting varnish is performed in an inert gas atmosphere at normal temperature and normal pressure but may be performed in an air atmosphere (in the presence of oxygen) as long as the compounds in the varnish are not decomposed or the composition does not greatly change or may be performed while performing heating.

Hereinafter, a method for producing an organic photoelectric conversion element using the charge transporting varnish of the present invention is described.

[Formation of anode layer]: Step of producing transparent electrode by forming layer of anode material on surface of transparent substrate

As the anode material, metal oxides such as indium tin oxide (ITO) and indium zinc oxide (IZO), and highly charge transporting organic compounds such as polythiophene derivatives and polyaniline derivatives can be used. In addition, as the transparent substrate, a substrate formed of glass or a transparent resin can be used.

The method for forming the layer of anode material (anode layer) is appropriately selected depending on the properties of the anode material, and either of a dry process (vapor deposition method) using a sublimable compound or a wet process (particularly a spin coating method or a slit coating method) using a varnish containing a charge

transporting compound is usually employed.

In addition, a commercially available product can also be suitably used as a transparent electrode, and it is preferable to use a base subjected to a smoothing treatment from the viewpoint of improving the yield of element in this case. In the case of using a commercially available product, the method for producing an organic photoelectric conversion element of the present invention does not include the step of forming an anode layer.

The transparent electrode to be used is preferably used after being washed with a detergent, an alcohol, pure water and the like. For example, the anode substrate is preferably subjected to a surface treatment such as UV/ozone treatment or oxygen-plasma treatment immediately before being used (the surface treatment may not be performed in a case in which the anode material contains an organic substance as a main component).

[Formation of hole collecting layer]: Step of forming hole collecting layer on layer of anode material

In accordance with the method for producing a charge transporting thin film described above, a hole collecting layer is formed on the layer of anode material using the charge transporting varnish of the present invention.

At this time, the thickness of the hole collecting layer is also usually about 1 to 200 nm but preferably about 3 to 100 nm and more preferably 3 to 30 nm in the same manner as described above.

[Formation of active layer]: Step of forming active layer on hole collecting layer

The active layer may be a laminate of an n layer that is a thin film formed of an n-type semiconductor material and a p layer that is a thin film formed of a p-type semiconductor material or a non-laminated thin film formed of a mixture of these materials.

Examples of the n-type semiconductor material include fullerene, [6,6]-phenyl-$C_{61}$-butyric acid methyl ester ($PC_{61}BM$), and [6,6]-phenyl-$C_{71}$-butyric acid methyl ester ($PC_{71}BM$). Meanwhile, examples of the p-type semiconductor material include regioregular poly(3-hexylthiophene) (P3HT), PTB7, PDTP-DFBT, polymers containing a thiophene skeleton in the main chain, such as thienothiophene unit-containing polymers as described in JP-A 2009-158921 and WO 2010/008672, phthalocyanines such as CuPC and ZnPC, and porphyrins such as tetrabenzoporphyrin.

Among these, $PC_{61}BM$ and $PC_{71}BM$ are preferable as the n-type material, and polymers containing a thiophene skeleton in the main chain such as PTB7 are preferable as the p-type material.

Incidentally, the "thiophene skeleton in the main chain" mentioned herein denotes a divalent aromatic ring composed only of thiophene or a divalent condensed aromatic ring containing one or more thiophenes such as thienothiophene, benzothiophene, dibenzothiophene, benzodithiophene, naphthothiophene, naphthodithiophene, anthrathiophene, or anthradithiophene, and these may be substituted with the substituents represented by $R^1$ to $R^6$ above.

The method for forming the active layer is appropriately selected depending on the properties of the n-type semiconductor or p-type semiconductor material, and either of a dry process (particularly, a vapor deposition method) using a sublimable compound or a wet process (particularly a spin coating method or a slit coating method) using a varnish containing the material is usually employed.

[Chem. 9]

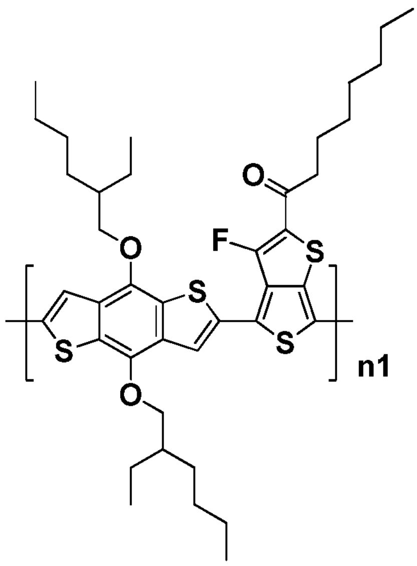

(PTB7)

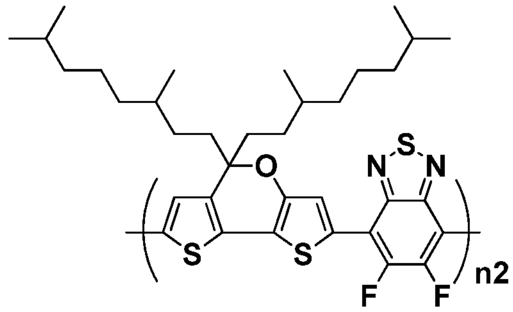

(PDTP-DFBT)

(Where n1 and n2 indicate the number of repeating units and denote a positive integer.)

[Formation of electron collecting layer]: Step of forming electron collecting layer on active layer

The electron collecting layer may be formed between the active layer and the cathode layer if necessary.

Examples of the material for forming the electron collecting layer include lithium oxide ($Li_2O$), magnesium oxide (MgO), alumina ($Al_2O_3$), lithium fluoride (LiF), magnesium fluoride ($MgF_2$), and strontium fluoride ($SrF_2$).

The method for forming the electron collecting layer is appropriately selected depending on the properties of the material thereof, and either of a dry process (particularly, a vapor deposition method) using a sublimable compound or a wet process (particularly a spin coating method or a slit coating method) using a varnish containing the material is usually employed.

[Formation of cathode layer]: Step of forming cathode layer on electron collecting layer

Examples of the cathode material include aluminum, magnesium-silver alloy, aluminum-lithium alloy, lithium, sodium, potassium, cesium, calcium, barium, silver, and gold. A plurality of cathode materials can be laminated or mixed for use.

The method for forming the cathode layer is appropriately selected depending on the properties of the material thereof, but a dry process (particularly, a vapor deposition method) is usually employed.

[Formation of carrier blocking layer]

A carrier blocking layer may be provided between arbitrary layers, if necessary, for the purpose of controlling the rectifying property of photoelectric current.

Examples of the material for forming the carrier blocking layer include titanium oxide and zinc oxide.

The method for forming the carrier blocking layer is appropriately selected depending on the properties of the material thereof, and usually a vapor deposition method is employed in the case of using a sublimable compound and either of a spin coating method or a slit coating method is employed in the case of using a varnish in which the material is dissolved.

The organic photoelectric conversion element fabricated by the method exemplified above is introduced again into the glove box and subjected to the sealing operation in an inert gas atmosphere such as nitrogen in order to prevent element deterioration by the air and can be allowed to exert the function as an organic photoelectric conversion element or subjected to the measurement of characteristics in the sealed state.

Examples of the sealing method include a method in which a concave glass substrate having a UV curable

resin attached to the end portion is attached to the film-formed surface side of the organic photoelectric conversion element in an inert gas atmosphere and the resin is cured by being irradiated with UV and a method in which film sealing type sealing is performed in a vacuum by techniques such as sputtering.

## EXAMPLES

Hereinafter, the present invention is more specifically described with reference to Examples and Comparative Examples, but the present invention is not limited to the following Examples. Incidentally, the apparatuses used are as follows.

(1) Glove box:
Glovebox System manufactured by VAC, USA

(2) Vapor deposition apparatus:
Vacuum Deposition Apparatus manufactured by Aoyama Engineering Co., Ltd.

(3) Measuring apparatus:
Fully Automatic Microfigure Measuring Instrument ET-4000A manufactured by Kosaka Laboratory Ltd.

(4) Apparatus used in current value measurement:
4156C Precision Semiconductor Parameter Analyzer manufactured by Agilent Technologies, Inc.

(5) Light source apparatus used in photoelectric current measurement:
SM-250 Hyper Mono Light System manufactured by Bunkoukeiki Co., Ltd.

[1] Preparation of active layer composition

[Preparation Example 1]

Into a sample bottle containing 20 mg of PTB7 (manufactured by 1-Material Inc.) and 30 mg of PCBM (product name: nanom spectra E100 manufactured by Frontier Carbon Corporation), 2.0 mL of chlorobenzene was added, and the mixture was stirred on a hot plate at 80°C for 15 hours. After this solution was cooled to room temperature, 60 μL of 1,8-diiodooctane (manufactured by Tokyo Chemical Industry Co., Ltd.) was added thereto, and the mixture was stirred to obtain active layer composition A1.

[2] Preparation of charge transporting varnish

[Production Example 1-1]

To a mixture of 58.3 mg (0.173 mmol) of N,N'-diphenylbenzidine represented by formula [1] (manufactured by Tokyo Chemical Industry Co., Ltd.) and 43.9 mg (0.277 mmol) of benzenesulfonic acid represented by formula [2] (manufactured by Tokyo Chemical Industry Co., Ltd.), 2.5 g of DMAc was added, and the resultant mixture was stirred while being irradiated with ultrasonic waves at room temperature for dissolution. Furthermore, 2.5 g of CHN was added thereto, and the mixture was stirred to obtain a brown solution.

The brown solution obtained was filtered through a syringe filter having a pore size of 0.2 μm to obtain a charge transporting varnish B1.

[Chem. 10]

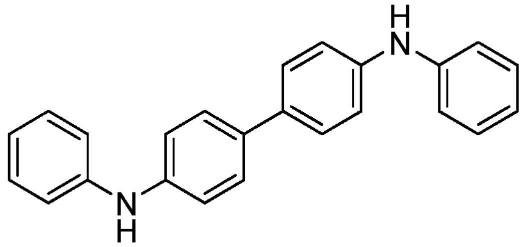

[1]

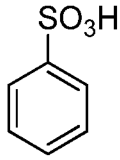

[2]

[3] Fabrication of hole collecting layer and organic photoelectric conversion element

[Example 1-1]

A 20 mm × 20 mm glass substrate on which an ITO transparent conductive layer to be the positive electrode was patterned in a 2 mm × 20 mm stripe shape was subjected to the UV/ozone treatment for 15 minutes, and then the substrate was coated with the charge transporting varnish B1 obtained in Example 1-1 by a spin coating method. This glass substrate was heated at 50°C for 5 minutes and further at 120°C for 10 minutes using a hot plate to form a hole collecting layer.

Thereafter, in the glove box substituted with an inert gas, the active layer composition A1 obtained in Preparation Example 1 was dropped on the hole collecting layer formed, and an active layer having a thickness of 100 nm was formed by a spin coating method.

Next, the substrate on which the organic semiconductor layer was formed and the mask for negative electrode were installed in a vacuum deposition apparatus, evacuation was performed until the degree of vacuum in the apparatus reached $1 \times 10^{-3}$ Pa or less, and an aluminum layer to be the negative electrode was deposited in a thickness of 80 nm by a resistance heating method.

Finally, heating was performed at 80°C for 10 minutes on a hot plate to fabricate an OPV element in which the area of the part at which the stripe-shaped ITO layer intersected with the aluminum layer was 2 mm × 2 mm.

[Example 1-2]

An OPV element was fabricated in the same manner as in Example 1-1 except that the heating temperature at the time of hole collecting layer formation was changed to 50°C for 5 minutes and further 150°C for 10 minutes.

[Example 1-3]

An OPV element was fabricated in the same manner as in Example 1-1 except that the heating temperature at the time of hole collecting layer formation was changed to 50°C for 5 minutes and further 180°C for 10 minutes.

[Comparative Example 1-1]

An OPV element was fabricated in the same manner as in Example 1-1 except that the heating temperature at the time of hole collecting layer formation was changed to 50°C for 5 minutes and further 230°C for 20 minutes.

[4] Evaluation on characteristics

The respective OPV elements fabricated above were subjected to evaluation on the short circuit current density (Jsc [mA/cm$^2$]), open circuit voltage (Voc [V]), fill factor (FF), and photoelectric conversion efficiency (PCE [%]). The results are presented in Table 1. Incidentally, the photoelectric conversion efficiency was calculated by the following equation.

$$\text{PCE (\%)} = \text{Jsc (mA/cm}^2) \times \text{Voc (V)} \times \text{FF} \div \text{incident light intensity (100 (mW/cm}^2)) \times 100$$

[Table 1]

| | Dopant | Baking temperature (°C) | $J_{SC}$ (mA/cm$^2$) | $V_{OC}$ (V) | FF | PCE (%) | Thickness of hole collecting layer (nm) |
|---|---|---|---|---|---|---|---|
| Example 1-1 | Benzenesulfonic acid | 120 | 11.5 | 0.74 | 0.66 | 5.7 | 5.8 |
| Example 1-2 | | 150 | 12.0 | 0.63 | 0.65 | 4.9 | <5 |
| Example 1-3 | | 180 | 12.1 | 0.58 | 0.64 | 4.5 | <5 |
| Comparative Example 1-3 | | 230 | 12.1 | 0.53 | 0.62 | 4.0 | <5 |

As presented in Table 1, it can be seen that an OPV element having an excellent photoelectric conversion efficiency is obtained in a case in which the hole collecting layer is formed at a baking temperature of 120°C, 150°C, or 180°C as in each of Examples.

On the other hand, it can be seen that the photoelectric conversion efficiency of the OPV element is considerably lower than that in Examples in a case in which the baking temperature is 230°C as in Comparative Example.

It can be seen that an organic photoelectric conversion element having an excellent photoelectric conversion efficiency can be obtained by setting the baking temperature in the range regulated in the present invention in this manner since film thinning in the hole collecting layer may be suppressed.

## Claims

**1.** A method for producing a charge transporting thin film, comprising applying a charge transporting varnish containing a charge transporting substance, an electron accepting dopant substance containing at least one kind selected from naphthalenesulfonic acid and benzenesulfonic acid, and an organic solvent on a substrate and heating the charge transporting varnish at 100°C to 180°C to evaporate the organic solvent.

**2.** The method for producing a charge transporting thin film of claim 1, wherein the charge transporting substance is a charge transporting substance having a molecular weight of 200 to 2,000.

**3.** The method for producing a charge transporting thin film of claim 1 or 2, wherein the charge transporting substance is at least one kind selected from an aniline derivative and a thiophene derivative.

**4.** The method for producing a charge transporting thin film of any one of claims 1 to 3, wherein the heating is performed for 1 to 30 minutes.

**5.** A method for producing an organic photoelectric conversion element, comprising a step of fabricating a charge transporting thin film by the production method of any one of claims 1 to 4.

**6.** A method for producing an organic photoelectric conversion element, comprising forming a charge transporting thin film on an anode layer by the production method of any one of claims 1 to 4, then applying an active layer composition on this thin film to form an active layer, and further forming a negative electrode on this active layer.

**7.** The method for producing an organic photoelectric conversion element of claim 5 or 6, wherein the organic photoelectric conversion element is an organic thin-film solar cell or an optical sensor.

**8.** A charge transporting varnish comprising a charge transporting substance; an electron accepting dopant substance containing at least one kind selected from naphthalenesulfonic acid and benzenesulfonic acid; and an organic solvent.

**9.** The charge transporting varnish of claim 8, comprising at least one kind selected from 1-naphthalenesulfonic acid and benzenesulfonic acid.

**10.** The charge transporting varnish of claim 8 or 9, which is used in formation of a hole collecting layer of an organic photoelectric conversion element.

11. The charge transporting varnish of claim 10, wherein the organic photoelectric conversion element is an organic thin-film solar cell or an optical sensor.

12. A charge transporting thin film to be fabricated from the charge transporting varnish of claim 8 or 9.

13. A hole collecting layer to be fabricated from the charge transporting varnish of claim 10.

14. The hole collecting layer of claim 13, which provides an organic photoelectric conversion element having a photoelectric conversion efficiency of 4.0% or more when being interposed between an anode and an active layer.

15. An organic photoelectric conversion element comprising the hole collecting layer of claim 13 and an active layer provided so as to be in contact with the hole collecting layer.

16. The organic photoelectric conversion element of claim 15, wherein the active layer contains a fullerene derivative.

17. The organic photoelectric conversion element of claim 15 or 16, wherein the active layer contains a polymer containing a thiophene skeleton in a main chain.

18. The organic photoelectric conversion element of any one of claims 15 to 17, which is an organic thin-film solar cell.

19. The organic photoelectric conversion element of any one of claims 15 to 17, which is an optical sensor.

## INTERNATIONAL SEARCH REPORT

International application No.
PCT/JP2018/018309

A. CLASSIFICATION OF SUBJECT MATTER
Int.Cl. H01L51/46(2006.01)i, C09D5/24(2006.01)i, C09D7/63(2018.01)i, C09D201/00(2006.01)i, H01B1/20(2006.01)i, H01L51/48(2006.01)i

According to International Patent Classification (IPC) or to both national classification and IPC

B. FIELDS SEARCHED
Minimum documentation searched (classification system followed by classification symbols)
Int.Cl. H01L31/02-31/078, H01L31/18-31/20, H01L51/42-51/48, H02S10/00-10/40, H02S30/00-99/00, H01L27/32, H01L33/00-33/28, H01L27/14-27/148, H01L27/30, H01L21/339, H01L29/762-29/768, C09D5/24, C09D7/63, C09D201/00, H01B1/20

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)
CAplus/REGISTRY (STN), Google Scholar

C. DOCUMENTS CONSIDERED TO BE RELEVANT

| Category* | Citation of document, with indication, where appropriate, of the relevant passages | Relevant to claim No. |
|---|---|---|
| A | WO 2016/148184 A1 (NISSAN CHEMICAL INDUSTRIES, LTD.) 22 September 2016 & EP 3273498 A1 & CN 107408633 A & KR 10-2017-0128409 A | 1-19 |
| A | JP 2015-213147 A (NISSAN CHEMICAL INDUSTRIES, LTD.) 26 November 2015 & KR 10-2015-0040216 A & CN 104629591 A | 1-19 |
| A | JP 2014-131057 A (NISSAN CHEMICAL INDUSTRIES, LTD.) 10 July 2014 & JP 2015-146438 A & WO 2010/058777 A1 | 1-19 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 June 2018 (07.06.2018) | 19 June 2018 (19.06.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2018/018309

C (Continuation). DOCUMENTS CONSIDERED TO BE RELEVANT

| Category* | Citation of document, with indication, where appropriate, of the relevant passages | Relevant to claim No. |
|---|---|---|
| A | WO 2015/087797 A1 (NISSAN CHEMICAL INDUSTRIES, LTD.) 18 June 2015 & US 2016/0315266 A1 & EP 3082171 A1 & CN 105934836 A & KR 10-2016-0096637 A | 1-19 |
| A | JP 2017-22299 A (SUMITOMO CHEMICAL CO., LTD.) 26 January 2017 & CN 106356461 A & KR 10-2017-0008683 A | 1-19 |
| A | WO 2009/096352 A1 (NISSAN CHEMICAL INDUSTRIES, LTD.) 06 August 2009 & US 2010/0320422 A1 & US 2013/0240795 A1 & EP 2246325 A1 & EP 2620427 A1 & KR 10-2010-0119876 A & CN 101959852 A | 1-19 |
| A | CN 103304469 A (OCEANS KING LIGHTING SCIENCE) 18 September 2013 (Family: none) | 1-19 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2005043962 A
- WO 2013042623 A
- WO 2014141998 A
- WO 2008010474 A
- WO 2014119782 A
- WO 2005000832 A
- WO 2006025342 A
- JP 2005108828 A
- WO 2010058777 A
- JP 2009158921 A
- WO 2010008672 A


### Non-patent literature cited in the description


- *Nature,* 1991, vol. 353, 737-740
- *Appl. Phys. Lett.,* 1986, vol. 48, 183-185
- *Nature Photonics,* 2012, vol. 6, 153-161
- *Scientific Reports,* 2015, vol. 5 (7708), 1-7